# EUROPEAN PATENT APPLICATION

(11) **EP 1 914 799 A1**
(43) Date of publication of application: **23.04.2008**
(21) Application number: 06775242.8
(22) Date of filing: 28.07.2006
(51) Int. Cl.: H01L 21/762, H01L 21/20, H01L 21/265, H01L 21/84

(54) **METHOD FOR MANUFACTURING SILICON ON INSULATOR**

(30) Priority: 29.07.2005 CN 200510028365
(71) Applicant: Shanghai Simgui Technology Co., Ltd, Jiading, Shanghai 201821 (CN)
(72) Inventor: CHEN, Meng, Jiading,Shanghai 201821 (CN)
(74) Representative: Schrell, Andreas
(86) International application number: PCT/CN2006/001901
(87) International publication number: WO 2007/012290

(57) **Abstract**

This invention refers to a method for manufacturing SOI wafers by combination of ion implantation with bonding process, wherein one forms an etch-stop layer by adopting ion implantation process, then bond the device wafer and handle wafer together, thin the device wafer to certain thickness and use the implanted layer in device wafer as etch stop layer, from where the etch automatically stops when one use chemicals etches the device wafer. Subsequently one does fine polishing with or oxidizes the remaining silicon to obtain an SOI wafer. Under this invention, the thickness of buried oxide can be adjusted in a wider range while the ion implanted layer acting as etch stop layer can help precisely control the thickness and uniformity of active layer, which enhances the uniformity of active layer and facilitates the adjustment of buried oxide layer.

## Description

### FIELD OF THE INVENTION

The invention relates to a process for manufacturing silicon-on-insulator, and more particularly, to a process for manufacturing silicon-on-insulator which combines ion implantation technology with bonding and thinning backside technology.

### DESCRIPTION OF THE RELATED ART

Silicon-on-insulator(SOI) has been widely used in aeronautic and astronautical fields, military electronics, portable communication devices etc. due to its advantageous properties of high speed, low power and anti-radiation etc., and is considered as a technology of next generation silicon integrated circuit(IC), thereby attracting more attentions(see J.P.Colige, Silicon on Insulator Technology, Material of VLSI, Kulwer Academic Publiction 1991). With the fast development of automotive electronics IC, audio power amplifier IC and lighting devices etc., there is an increasing demand for power devices. The application of SOI substrates to power devices has arrested much attention due to its outstanding insulation property (see F. Udrea, D. Garner, K. Sheng, A.Popescu, H.T. Lim and W.I. Milne, SOI Power Devices, Electronics and communication Engineering Journal, Feb. 2000, p27).

Separation by Implanted Oxygen (SIMOX) technology and Bonding and Thinning backside technology are two of the mainstream SOI fabrication methods available nowadays. In the SIMOX, an SOI structure is formed by implanting high dose oxygen ions into monocrystalline silicon wafers and forming a buried, insulating silicon dioxide (SiO₂) layer (BOX) after performing a high temperature annealing on the monocrystalline silicon wafers. In the Bonding and thinning backside technology, an SOI structure is formed by bonding one thermally oxidized silicon wafer with a bare silicon wafer and then thinning a backside of the wafer to a desired thickness.

In the SIMOX process, oxygen ions with high energy (20-300KeV) and high dosage (10¹⁷-10¹⁸cm⁻²) are implanted into a silicon wafer, and a rich-oxygen area is generated at a certain depth in the silicon wafer and then a SiO₂ layer buried in the silicon wafer(i.e. BOX layer) is formed after performing a high temperature annealing. In the SIMOX process, the adjustable thickness ranges of the BOX layer and a top silicon layer (active layer) are limited by the energy and dose of the implanted ions. The maximum thickness of BOX layer will not exceed 400nm while the maximum thickness of the top silicon layer is about 300nm. Further, in the SIMOX process, the BOX layer is formed by performing a high temperature annealing to facilitate the oxygen aggregation into nucleus, which makes the insulation property of the BOX layer inferior to that of SiO₂ layer formed by thermal oxidation. These disadvantages impede SIMOX applications in terms of thick BOX layers (>400nm) and thick top silicon layers (>300nm).

The bonding and thinning process involves bonding one silicon wafer with a surface covered by a thermal oxidation layer to another bare silicon wafer, and thinning the backside of the bonded silicon wafer to a desired thickness. In the bonding and thinning process, the quality of BOX layer can be well controlled whereas the thickness of a top silicon layer (active layer) can hardly be controlled precisely. J.W. Neuner employed a plasma-aided chemical etching method to thin the top silicon layer, which achieved a top silicon layer with a thickness of 1um and an uniformity within ±0.1 µm (see J.W. Neuner, A.M. Ledger, S.K.Schilb, and D.P.Mathur, Improved Uniformity in Bonded SOI wafers with Active Layers from 1 to 30 µm at high throughputs, Proceedings 1998 IEEE International SOI Conference, Oct. 1998, p.169-170). However, it becomes more and more difficult to obtain a thinner thickness and better uniformity by means of polishing or etching the top silicon layer. These disadvantages also impede the application of the bonding and thinning process in fields that require high uniformity.

Based on the conventional bonding and thinning process, the France-based SOITEC proposed a new technology called Unibond. One of the key steps in this process involves forming a bubble layer by implanting hydrogen ions in a wafer. This bubble layer splits automatically during a subsequent annealing process, as a result of which the SOI uniformity as well as the thickness of the top silicon layer is precisely controlled prior to polishing which is determined by the uniform hydrogen ions implantation.

### SUMMARY OF THE INVENTION

The invention relates to a process for manufacturing silicon-on-insulator (SOI) wafers, which combines ion implantation process with bonding and thinning process and has the following advantages: the thickness of the top silicon layer is thin, and the uniformity of which can be well controlled by oxygen ion implantation, while the thickness of BOX layer can be adjusted in a large range feasibly by thermal oxidation process and the insulation property of which is good, thereby achieving a high quality SOI wafers with a feasible BOX layer thickness and a good uniformity of the top silicon layer.

This invention comprises the following steps: First, forming a device wafer by an ion implantation process (In the case of requiring a thick top silicon layer, an epitaxial layer has to be grown on the implanted wafer or an epitaxial layer is grown on the top silicon layer upon completion of a final process. In these cases, the wafer is still called device wafer), bonding the device wafer (or device wafer with an oxidation layer) to a handle wafer (or an oxidation handle wafer), performing an annealing on the resultant wafer in an atmosphere of oxygen or water vapor to strengthen the bonding, then etching the device wafer by grinding and etching processes until the implanted layer (i.e. an etching stop layer) is exposed, subsequently etching out the etching stop layer followed by performing a fine polishing or oxidation treatment on the top silicon layer, thereby forming a finished SOI wafer. The final thicknesses of the BOX layer and the top silicon layer are depended on the thicknesses of the oxidation layer and the implantation depth (or the thickness of the epitaxial layer) of the device wafer respectively.

In details, the method for manufacturing SOI wafers according to the invention includes the following steps:
[1] Implanting ions: implanting ions into the semiconductor materials to form an ion implanted layer by an appropriate ion implantation process;
[2] Performing a high temperature treatment on the ion implanted wafer to form an etching stop layer for a subsequent etching process;
[3] Using the aforementioned wafer (which undergoes implantation and annealing process or has an epitaxial layer) as a device wafer;
[4] Insulating the device wafer or a handle wafer in accordance with the requirement for a buried layer (insulation layer) thickness;
[5] Bonding the device wafer to the handle wafer;
[6] Annealing the bonded wafer;
[7] Polishing the backside of the device wafer to a certain thickness;
[8] Etching the device wafer until the ion implanted layer is exposed fully;
[9] Removing the ion implanted layer;
[10] Performing a fine polishing or oxidation process on the remaining top silicon layer to achieve a desired thickness.

The above-mentioned semiconductor material can be one of silicon, gallium arsenide (GaAs), indium phosphide, and germanium(Ge).

The aforesaid device wafer is fabricated by ion implantation process. The ion can be nitrogen(N) ion, oxygen(O) ion or other ions. The ions is selected in such a way that the ion layer implanted layer can act as an etching stop layer. O ion is preferred.

The implantation energy of ions ranges from 10 KeV to 500 KeV, preferably from 70 KeV to 250 KeV, and the implantation dose of ions ranges from 1E15/cm² to 1E19/cm², preferably from 5E16/cm² to 2E18/cm².

The implanted depth of ions ranges from 500 to 10000 angstroms(Å), and the ion implantation process may be performed at a constant temperature or a varying temperature, which ranges from 20 to 700°C .

The aforesaid implantation can performed by using the well-established SIMOX implanter based on SIMOX process.

The process conditions for the SIMOX process are as follows: the implantation energy of oxygen ions ranging from 30 KeV to 250 KeV, preferably from 70 KeV to 250 KeV, and the implantation dose of oxygen ions ranging from 5E16/cm² to 2E18/cm² preferably from 5E16/cm² to 7E17/cm², an preferred implantation depth ranging 1000 to 5000 Å and an implantation temperature ranging from 20 to 550°C.

The aforesaid device wafer can be subjected to a subsequent treatment (including a high temperature annealing) for the purpose of making the interface of the implanted layer and non-implanted layer precipitous, which facilitates the stop of chemical etching at the interface.

The aforesaid subsequent high temperature annealing process can be performed at a temperature ranging from 600 to 1500°C, in a ramp up/down rate ranging from 0.5 to 10°C/minute under an atmosphere of mixed gases of oxygen and argon or oxygen and nitrogen, in which the oxygen concentration ranges from 0% to 100%.

The aforesaid device wafer can not be subjected to the subsequent treatment, provided that the implantation dose is large and an etching stop layer can be formed against some particular chemical etching without a subsequent high temperature annealing.

The aforesaid device wafer can be formed by performing a high temperature annealing on the implanted wafer followed by removing the surface SiO₂ layer or without removing the same; the SiO₂ layer formed by the high temperature annealing can be removed by using a commonly used dilute solution of HF in the art. If the SiO₂ layer is not removed, it will become a part of the buried SiO₂ layer of finished SOI wafer.

The subsequent high temperature annealing can be performed at a temperature ranging from 1100°C to 1350°C , preferably in an atmosphere containing an oxygen concentration ranging from 0% to 60%.

The aforesaid etching process may be a chemical etching or a plasma etching or any other method that enables etching stop at the ion implantation layer.

Depending on the requirement for the top silicon layer thickness, the surface SiO₂ layer can be removed firstly and then an epitaxial layer can be grown to a certain thickness by an epitaxial method, i.e., an epitaxial layer is formed on the top silicon layer of the initial implanted wafer. The epitaxial process can be a conventional process commonly used in the semiconductor industry. The epitaxy can either be homogeneous or heterogenous. The epitaxial layer can be P- or N- type and can be doped with phosphor or boron or others dopants.

The aforesaid insulation layer resulting from insulation treatment or oxidation treatment will serve as the buried layer of the final SOI wafers.

The aforesaid insulation layer can be made of SiO₂ silicon nitride (Si₃N₄) or other material that has insulation property. The insulation treatment can be carried out on the device wafer or the handle wafer or on both.

The aforesaid insulation treatment refers to a method for growing insulation layer, such as an oxidation method for growing SiO₂ or a nitridation method for growing Si₃N₄. SiO₂ is usually used as an insulation layer, So the thus formed insulation layer acts as aburied layer of the final SOI wafer. The thickness of the buried SiO₂ layer ranges from 0.1 to 5 µm. The total thickness of the device wafer, the handle wafer and the buried SiO₂ layer is the thickness of the final SOI wafer.

The aforesaid oxidation process can be a conventional process commonly used in IC industry, such as dry oxygen oxidation process or dry oxygen-wet oxygen-dry oxygen oxidation process.

The aforesaid oxidized silicon can be grown on the device wafer or the handle wafer.

SiO₂ layer is usually used as an insulation layer.

The device wafer and the handle wafer are bonded by a bonding process.

The bonding process can be performed by using the EVG bonding machine manufactured by EVG Group or using other types of bonding machines, and usually at room temperature. A plasma-assisted bonding process can be used for this purpose at room temperature.

The aforesaid annealing can be performed in an atmosphere containing oxygen, which can be either dry oxygen, wet oxygen or a mixed gas.

The aforesaid annealing can be performed at a temperature ranging from 200°C to 1400°C for a period from 0.5 hour to 15 hours.

Preferably, the aforesaid annealing can be performed at a temperature ranging from 1000°C to 1250°C for a period from 2 hours to 6 hours in a wet oxygen atmosphere.

The aforesaid single side thinning can be performed by a grinder or other machines that enable a silicon wafer thinning. The thickness after thinning ranges from 1 µm to 100 µm, preferably from 3 µm to 30 µm.

In the etching process, the etch selectivity ratio of material to be etched to the ion implanted layer should be large enough to make the etching stop at the ion implanted layer.

The etchant used in the aforesaid etching process may include potassium hydroxide (KOH), Tetramethyl Ammonium Hydroxide (TMAH) or other chemicals that has large etch selectivity ratio of silicon to the ion implanted layer.

In general, KOH solution or TMAH solution is selected as an etchant to etch silicon. The ratio of chemical (such as KOH or TMAH) to deionized water in the etchant is 1:1000, preferably from 1:1 to 1:100. When etching, it needs heating the etchant to a temperature ranging from 25°C to 200°C , preferably from 50°C to 150°C.

In addition to the aforesaid etching method, the implanted layer can also be removed directly by a polishing method.

The implanted layer can be removed by a chemical etchant selected appropriately. If the implanted layer is SiO₂ layer, HF solution can be selected as the chemical etchant.

In the HF solution, the ratio of solute to solvent ranges from 1:1 to 1:2000, preferably from 1:10 to 1:100.

Chemical Mechanical Polishing (CMP) or oxidation can be selected as a fine polishing process to adjust the thickness of the top silicon layer in the final SOI wafer and achieve a more smooth surface. The thickness of silicon layer removed by CMP ranges from 300Å to 5000Å, preferably from 300Å to 3000Å. The thickness of silicon layer removed by oxidation ranges from 300Å to 10000Å and preferably from 300Å to 5000Å.

A top silicon layer in the nano scale can be achieved in the implanted wafer formed by an implantation process. The minimum thickness of the top silicon layer can be 30nm, and thickness uniformity is excellent with a thickness deviation of ± 10nm. The thickness and uniformity can not be achieved by bonding and thinning process singly. When a SOI wafer is formed by bonding and thinning process singly, the thickness of BOX layer in the SOI wafer can be adjusted in a wider range since it is produced by a thermal oxidation process.

This invention combines the advantages of both processes above. In the SOI wafers fabricated according to the present invention, the BOX layer formed by a thermal oxidation process has good insulation property and an adjustable, uniform thickness (in a range of 0~5.0µm), and the top silicon layer is a transplanted layer from an implanted wafer or an implanted wafer with an epitaxial layer. The etching stop layer of the implanted wafer ensures the thickness and uniformity of the top silicon layer prior to a final fine polishing (thickness uniformity is excellent with a thickness deviation of ± 10nm), and therefore the final thickness deviation of the SOI wafer can be controlled within ± 0.05um.

### BRIEF DESCRIPTION OF THE DRAWINGS

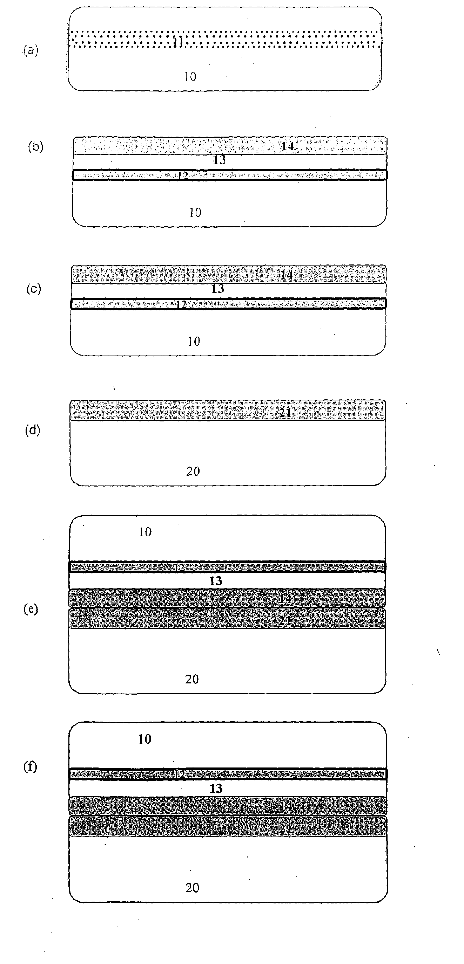

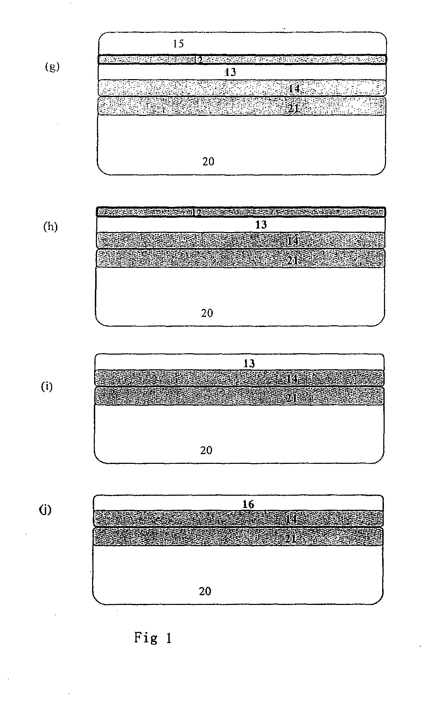

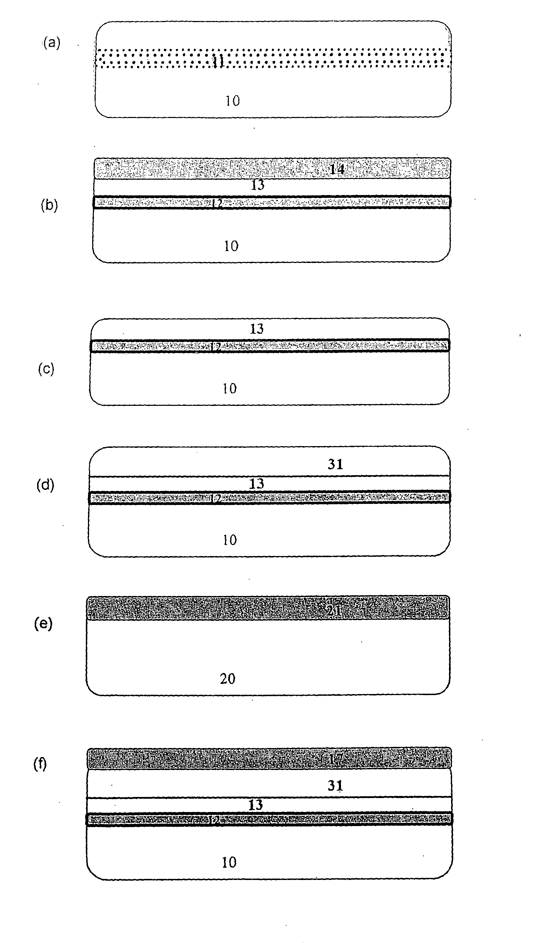

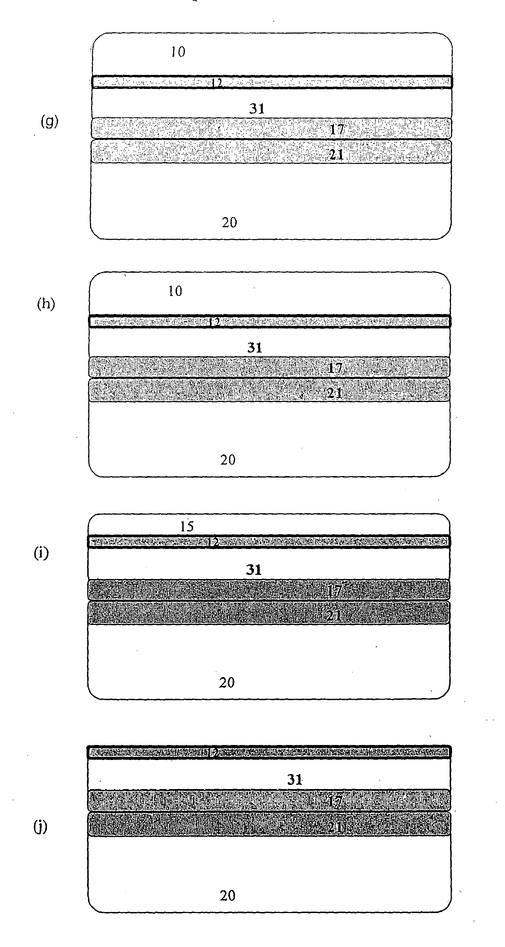

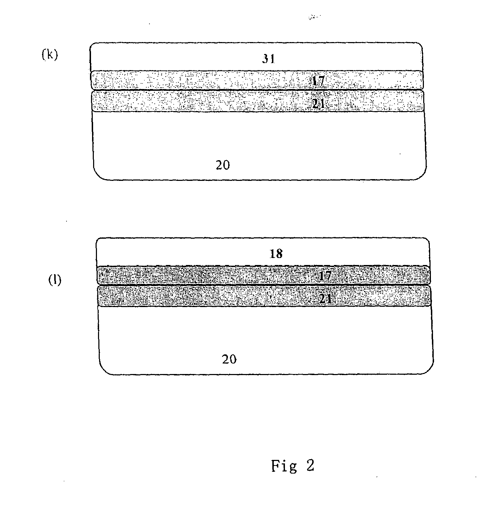

Fig. 1 is a flow diagram illustrating a method of manufacturing a SOI wafer according to a first embodiment of the present invention, wherein:
   a. Implanting ions
   b. Performing a high temperature annealing process to form a etching stop layer
   c. Forming a device wafer
   d. Oxidizing a handle wafer
   e. Bonding the device wafer to the handle wafer
   f. Oxidizing the bonded wafer
   g. Back grinding the device wafer and thinning the thickness thereof to a certain thickness
   h. Etching the device wafer until the ion implanted layer is expose fully
   i. Removing the ion implanted layer
   j. performing a fine polishing on the remaining top silicon layer to form a finished SOI wafer
Fig.2 is a flow diagram illustrating a method of manufacturing a SOI wafer according to a second embodiment of the present invention, wherein:
   a. Implanting ions
   b. Performing a high temperature annealing process to form a etching stop layer
   c. Removing the oxide layer formed by the high temperature annealing process on the surface
   d. Growing an epitaxial layer on a device wafer
   e. Oxidizing a handle wafer
   f. Oxidizing the device wafer with an epitaxial layer
   g. Bonding the device wafer to the handle wafer
   h. Oxidizing the bonded wafer
   i. Back grinding the device wafer and thinning the thickness thereof to a certain thickness
   j. Etching the device wafer until the ion implanted layer is expose fully
   k. Removing the ion implanted layer
   l. performing a fine polishing on the remaining top silicon layer to form a finished SOI wafer
Fig 3 is a diagram illustrating the test results for the thickness and uniformity of SOI wafers according to the first embodiment of the present invention.
Fig 4 is a diagram illustrating the test results for the thickness and uniformity of SOI wafers according to the second embodiment of the present invention.

### SPECIFIC EMBODIMENTS OF THE INVENTION

The above objects, features and advantages of the present invention will become better understood with respect to the following description of the preferred embodiments given in conjunction with the accompanying drawings. But the embodiments are only illustrative but nor limitative.

### First Embodiment

Step 1: Implanting oxygen ions into the prime polished wafer 10 with an energy of 190KeV and a dose of 3E17/cm² at a temperature of 300°C , and the implanted layer is marked as 11.
Step 2: Annealing the implanted wafer at a temperature of 1330°C in an argon atmosphere containing 0.5% oxygen.
Step 3: obtaining a wafer 10 having an etching stop layer, wherein the thickness of the top silicon layer is about 230±5nm, the buried layer is about 90±5nm and the surface SiO₂ layer is 400±5nm. The implanted layer 11 turns into an etching stop layer 12 (i.e. the buried layer). The top silicon layer, the surface SiO₂ layer are marked as 13 and 14 respectively.
Step 4: Oxidizing a silicon wafer 20. The thickness of the resultant oxidation layer is about 600±5nm and is marked as 21.
Step 5: Bonding the silicon wafer 10 to the silicon wafer 20, followed by an annealing process at a temperature of about 1150°C. The bonded wafer is oxidized by water vapor for 3 hours.
Step 6: Thinning the annealed wafer 10 at backside by a grinding machine, the remaining wafer has a thickness of 15 micron (µm), and is marked as 15.
Step 7: Etching the thinned wafer by KOH etchant at a temperature of 70 °C for about 25 minutes to remove the remaining wafer 15, wherein the mass ratio of deionized water to KOH in the etchant is 1:20.
Step 8: Rinsing the resultant wafer in the 1:10 HF solution for 30 seconds to remove the etching stop layer 12.
Step 9: Polishing the top silicon layer 13 by a CMP machine until about 50nm thickness is removed. The remaining top silicon layer is remarked as 16.

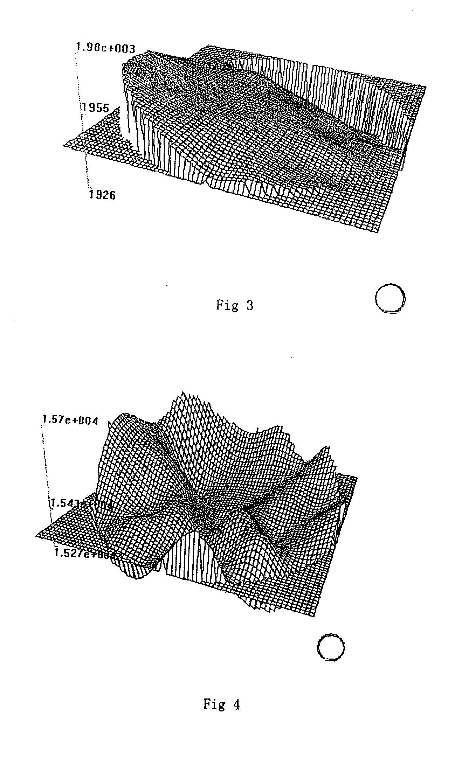

After the above steps, a SOI wafer is obtained with parameters as follows: the top silicon layer 16 has a 195.3 nanometers (nm) thickness and has an excellent uniformity with a thickness deviation of ±2.7nm. The buried layer is the sum of 14 plus 21, with a total thickness of 1000±10nm. The test data for uniformity of the top silicon layer 16 is shown in Fig. 3.

### Second Embodiment

Step 1: Implanting oxygen ions into the prime polished wafer 10 with an energy of 190KeV and a dose of 2.5E17/cm² at a temperature of 300°C, and the implanted layer is marked as 11.
Step 2: Annealing the implanted wafer at a temperature of 1330°C in an argon atmosphere containing oxygen.
Step 3: obtaining a wafer 10 having an etching stop layer, wherein the thickness of the top silicon layer is about 230±5nm, the buried layer is about 90±5nm and the surface SiO₂ layer is 400±5nm. The implanted layer 11 turns into an etching stop layer 12 (i.e. the buried layer). The top silicon layer, the surface SiO₂ layer are marked as 13 and 14 respectively.
Step 4: Cleaning the wafer 10 and removing the surface SiO₂ layer 14, and then growing an epitaxial layer which has a thickness of 1.40µm and is marked as 31.
Step 5: Oxidizing the wafer 10 with the epitaxial layer 31 at a temperature of 1000°C . The resultant oxidation layer has a thickness of 200nm±10nm, and is marked as 17.
Step 6: Oxidizing a silicon wafer 20. The thickness of the resultant oxidation layer is about 600±5nm and is marked as 21.
Step 7: Bonding the silicon wafer 10 to the silicon wafer 20, followed by an annealing process at a temperature of about 1150°C. The bonded wafer is oxidized by water vapor for 3 hours.
Step 8: Thinning the annealed wafer 10 at backside by a grinding machine, the remaining wafer has a thickness of 15 micron (µm), and is marked as 15.
Step 9: Etching the thinned wafer by KOH etchant at a temperature of 70 °C for about 25 minutes to remove the remaining wafer 15, wherein the mass ratio of deionized water to KOH in the etchant is 1:20.
Step 10: Rinsing the resultant wafer in the 1:10 HF solution for 30 seconds to remove the etching stop layer 12.
Step 11: Polishing the epitaxial layer 31 by a CMP machine until about 100nm thickness is removed. The remaining epitaxial layer is remarked as 18.

After the above steps, a SOI wafer is obtained with parameters as follows: the epitaxial layer 18 has a 1.548 µm thickness and has an excellent uniformity with a thickness deviation of ±21.5nm. The buried layer is the sum of 17 plus 21, with a total thickness of 1000±10nm. The test data for uniformity of the epitaxial layer 18 is shown in Fig.4.

While the present invention has been described with respect to certain preferred embodiments, it will be apparent to those skilled in the art that various changes and modifications may be made without departing from the spirit and scope of the invention as defined in the following claims.

## Claims

1. A process for manufacturing a silicon-on-insulator (SOI) wafer, **characterized in that** firstly forming a device wafer by an ion implantation process, or forming a device wafer either by growing an epitaxial layer on an ion implanted wafer or by growing an epitaxial layer on a top silicon layer upon completion of a final process; then bonding the device wafer or oxidized device wafer to a handle wafer or an oxidized handle wafer; annealing the resultant wafer to strengthen the bonding; then etching the device wafer by grinding and etching until the implanted layer is exposed; removing the etching stop layer followed by performing a fine polishing or oxidation treatment on the top silicon layer, thereby forming a finished SOI wafer; the thickness of the buried insulation layer and the thickness of the top silicon layer in the finished SOI wafer are determined by the thickness of the oxidation layer and the thickness of the implantation depth or the thickness of the epitaxial layer of the device wafer respectively.

2. A process for manufacturing a silicon-on-insulator (SOI) wafer as claimed in claim 1, comprising:
[1] Implanting ions into a semiconductor wafer to form an ion implanted layer, wherein the semiconductor wafer is made of silicon, gallium arsenide (GaAs), indium phosphide, or germanium(Ge);
[2] Performing a subsequent high temperature treatment on the ion implanted wafer to form an etching stop layer for a subsequent etching process;
[3] Directly using the implanted and subsequently processed wafer as a device wafer, or growing an epitaxial layer on the wafer and using the same as a device wafer;
[4] Insulating the device wafer or a handle wafer in accordance with the requirement for the thickness of a buried insulation layer by a high temperature annealing, etching or epitaxial growing process, wherein the temperature annealing process is performed at a temperature of 600~1500 °C in an atmosphere of mixed gases of oxygen and argon gas, or oxygen and nitrogen gas, the etching process includes a chemical etching or plasma etching process;
[5] Bonding the device wafer to the handle wafer;
[6] performing an annealing process on the bonded wafer at a temperature of 500~1400°C in a dry oxygen atmosphere, a wet oxygen atmosphere or a mixed atmosphere containing oxygen for 0.5~1.5hours;
[7] Back grinding (single sided grinding) the device wafer to thin the thickness thereof to 1~100µm;
[8] Etching the device wafer until the ion implanted layer is entirely exposed;
[9] Removing the ion implanted layer by an etching or a polishing process;
[10] Performing a fine polishing or oxidation process on the remaining top silicon of the device.

3. A process for manufacturing a silicon-on-insulator (SOI) wafer as claimed in claim 1 or 2, **characterized in that** the ion implantation is performed at an ion implantation energy ranging from 10 KeV to 500 KeV, with a dose from 1E15/cm² to 1E19/cm², and an implantation depth from 500 to 10000 Å and an implantation temperature from 20 to 700°C .

4. A process for manufacturing a silicon-on-insulator (SOI) wafer as claimed in claim 1 or 2, **characterized in that** the implantation energy of the ions ranges from 70 KeV to 250 KeV, and the implantation dose of the ions ranges from 5E16/cm² to 2E18/cm².

5. A process for manufacturing a silicon-on-insulator (SOI) wafer as claimed in claim 1 or 2, **characterized in that** the oxygen ion implantation is performed by using a SIMOX process.

6. A process for manufacturing a silicon-on-insulator (SOI) wafer as claimed in claim 3, **characterized in that** the implantation dose ranges from 5E16/cm² to 7E17/cm², the implantation depth ranges from 1000 to 5000 Å, and the implantation temperature ranges from 20 to 550°C.

7. A process for manufacturing a silicon-on-insulator (SOI) wafer as claimed in claim 2, **characterized in that** the subsequent high temperature treatment is performed at a temperature ranging from 600 to 1500°C under an atmosphere of mixed gases of oxygen and argon gas, or oxygen and nitrogen gas, in which the oxygen concentration ranges from 0% to 100%.

8. A process for manufacturing a silicon-on-insulator (SOI) wafer as claimed in claim 7, **characterized in that** the subsequent high temperature treatment is performed at a temperature ranging from 1100°C to 1350°C in an atmosphere containing an oxygen concentration ranging from 0% to 60%.

9. A process for manufacturing a silicon-on-insulator (SOI) wafer as claimed in claim 2, **characterized in that** depending on the requirement for the top silicon layer thickness, the surface SiO₂ layer is removed firstly, and then an epitaxial layer is grown on the top silicon layer to a certain thickness by an epitaxial process, the epitaxial process can be a conventional process commonly used in the semiconductor industry; the epitaxy is a homogeneous or heterogenous epitaxy; and the epitaxial layer is P- or N- type and is doped with phosphor or boron or others dopants.

10. A process for manufacturing a silicon-on-insulator (SOI) wafer as claimed in claim 2, **characterized in that** during the subsequent high temperature treatment, the temperature increases from room temperature to a temperature of 1350°C at a rate of 0.5°C /minute to 10°C /minute in a atmosphere of mixed gases of oxygen and argon gas, or oxygen and nitrogen gas that contains an oxygen concentration of 0-100%; the temperature decreases from a temperature of 1350°C to room temperature at a rate of 0.5°C /minute to 10°C /minute in an atmosphere of mixed gases of oxygen and argon gas, or oxygen and nitrogen gas that contains an oxygen concentration of 0-100%.

11. A process for manufacturing a silicon-on-insulator (SOI) wafer as claimed in claim 2, **characterized in that** during the subsequent high temperature treatment, the temperature can increase/decrease in a single temperature ramp up/down step, or in multiple temperature ramp up/down steps.

12. A process for manufacturing a silicon-on-insulator (SOI) wafer as claimed in claim 2, **characterized in that** after the step (1) and (2), the etching stop layer resulted from the ion implantation process has a thickness from 200Å to 5000Å, the surface SiO₂ layer has a thickness from 1000Å to 15000Å and the top silicon layer has a thickness from 200Å to 4000Å.

13. A process for manufacturing a silicon-on-insulator (SOI) wafer as claimed in claim 2 or 12, **characterized in that** after the step (1) and (2), the etching stop layer resulted from the ion implantation process has a thickness from 500Å to 1500Å, the surface SiO₂ layer has a thickness from 1500Å to 10000Å.

14. A process for manufacturing a silicon-on-insulator (SOI) wafer as claimed in claim 2, **characterized in that** the device wafer is formed by performing a high temperature annealing on the implanted wafer followed by removing the surface SiO₂ layer or not removing the same; if the SiO₂ layer formed by the high temperature annealing is removed, it can be removed by using a commonly used dilute solution of HF in the art; If the SiO₂ layer is not removed, it will become a part of the buried SiO₂ layer of finished SOI wafer.

15. bA process for manufacturing a silicon-on-insulator (SOI) wafer as claimed in claim 2, **characterized in that** an insulation layer is formed by the insulation treatment or oxidation treatment, the insulation layer is made of SiO₂, Si₃N₄, or other material having insulation property, and the insulation treatment refers to a method for growing an insulation layer, such as an oxidation method for growing SiO₂ or a nitridation method for growing Si₃N₄.

16. A process for manufacturing a silicon-on-insulator (SOI) wafer as claimed in claim 2, **characterized in that** the insulation treatment is carried out on the device wafer or on the handle wafer or on both.

17. A process for manufacturing a silicon-on-insulator (SOI) wafer as claimed in claim 15, **characterized in that** the oxidation process for the silicon wafer is a dry oxygen oxidation process or dry oxygen-wet oxygen-dry oxygen oxidation process used in IC industry.

18. A process for manufacturing a silicon-on-insulator (SOI) wafer as claimed in claim 15, **characterized in that** the thickness of the silicon wafer to be treated in the oxidation process is from 0.1 to 5 µm.

19. A process for manufacturing a silicon-on-insulator (SOI) wafer as claimed in claim 15, **characterized in that** the total thickness of the device wafer and the handle wafer is the thickness of the final SOI wafer.

20. A process for manufacturing a silicon-on-insulator (SOI) wafer as claimed in claim 1 or 2, **characterized in that** the annealing process is performed at a temperature ranging from 200°C to 1400°C in an atmosphere containing oxygen, an atmosphere of dry oxygen, an atmosphere of wet oxygen or an atmosphere of mixed gases for a period from 0.5 hour to 15 hours.

21. A process for manufacturing a silicon-on-insulator (SOI) wafer as claimed in claim 20, **characterized in that** the annealing process is preferably performed at a temperature ranging from 1000°C to 1250°C in a wet oxygen atmosphere for a period from 2 hours to 6 hours.

22. A process for manufacturing a silicon-on-insulator (SOI) wafer as claimed in claim 2, **characterized in that** the single side thinning is performed by a grinder or other machines that capable of thinning a silicon wafer, and the thickness after thinning ranges from 1 µm to 100 µm.

23. A process for manufacturing a silicon-on-insulator (SOI) wafer as claimed in claim 22, **characterized in that** the thickness after thinning ranges from 3 µm to 30 µm.

24. A process for manufacturing a silicon-on-insulator (SOI) wafer as claimed in claim 2, **characterized in that** the etchant used in the etching process includes a solution of potassium hydroxide (KOH), Tetramethyl Ammonium Hydroxide (TMAH) or other chemicals that have a large etch selectivity ratio to the ion implanted layer and silicon.

25. A process for manufacturing a silicon-on-insulator (SOI) wafer as claimed in claim 24, **characterized in that** the ratio of KOH or TMAH to deionized water in the etchant is 1:1000, and the etching temperature is in a range from 25 °C to 200°C .

26. A process for manufacturing a silicon-on-insulator (SOI) wafer as claimed in claim 25, **characterized in that** the ratio of the chemical to deionized water in the etchant is in a range from 1:1 to 1:100, and the etching temperature is in a range from 50°C to 150°C .

27. A process for manufacturing a silicon-on-insulator (SOI) wafer as claimed in claim 2, **characterized in that** in the step(9), the implanted layer is removed by a etching process or directly by a polishing process.

28. A process for manufacturing a silicon-on-insulator (SOI) wafer as claimed in claim 2 or 27, **characterized in that** the implanted layer is a SiO₂ layer, and HF solution with a concentration from 1:1 to 1:2000 is selected as the etchant.

29. A process for manufacturing a silicon-on-insulator (SOI) wafer as claimed in claim 28, **characterized in that** the concentration of HF solution is in a range from 1:10 to 1:100.

30. A process for manufacturing a silicon-on-insulator (SOI) wafer as claimed in claim 2, **characterized in that** in the step(10), the thickness of silicon layer removed by CMP ranges from 300Å to 50000Å to ensure the uniformity of the thickness of the final SOI wafer.

31. A process for manufacturing a silicon-on-insulator (SOI) wafer as claimed in claim 30, **characterized in that**, the thickness of silicon layer removed by CMP ranges from 300Å to 3000Å.

32. A process for manufacturing a silicon-on-insulator (SOI) wafer as claimed in claim 2, **characterized in that** in the step(10), the thickness of silicon layer removed by oxidation treatment ranges from 300Å to 10000Å.

33. A process for manufacturing a silicon-on-insulator (SOI) wafer as claimed in claim 32, **characterized in that**, the thickness of silicon layer removed by oxidation treatment ranges from 300Å to 5000Å.
